# EUROPEAN PATENT APPLICATION

(11) **EP 4 764 775 A1**
(43) Date of publication of application: **24.06.2026**
(21) Application number: 25190459.5
(22) Date of filing: 18.07.2025
(51) Int. Cl.: G06F 1/16, G09F 9/30

(54) **DISPLAY DEVICE**

(30) Priority: 20.12.2024 KR 20240192358
(71) Applicant: LG Display Co., Ltd., Seoul, 07336 (KR)
(72) Inventor: AN, Hyeonggwang, Paju-si, Gyeonggi-do 10845 (KR); OH, JiSoon, Paju-si, Gyeonggi-do 10845 (KR); WOO, Sangmin, Paju-si, Gyeonggi-do 10845 (KR); LEE, Jaewoo, Paju-si, Gyeonggi-do 10845 (KR); CHA, Jongseok, Paju-si, Gyeonggi-do 10845 (KR); LEE, ShinSuk, Paju-si, Gyeonggi-do 10845 (KR); LEE, Namseok, Paju-si, Gyeonggi-do 10845 (KR)
(74) Representative: Viering, Jentschura & Partner mbB Patent- und Rechtsanwälte

(57) **Abstract**

The present disclosure relates to a display device (100). A display device (100) according to exemplary embodiments of the present disclosure may include a display panel (110) including a folding area (FA) and a non-folding area (NFA), at least a portion of the display panel (110) being foldable; a first wing plate (210) overlapping the rear surface of the display panel (110); a cover (250) overlapping at least a portion of the first wing plate (210); a link arm (270) having a curved shape and inserted between the first wing plate (210) and the cover (250); and a second wing plate (290) connected to the link arm (270) and overlapping the rear surface of the display panel (110). As the display panel (110) is folded, at least a portion of the second wing plate (290) may rotate in accordance with the curved shape.

## Description

### CROSS-REFERENCE TO RELATED APPLICATION

This application claims priority and benefit from Korean Patent Application No. 10-2024-0192358, filed on December 20, 2024.

### Technical Field

Exemplary embodiments of the present disclosure relate to a display device, and more specifically, for example, without limitation, to a display device in which a plurality of wing plates are disposed on a rear surface of a display panel.

### BACKGROUND

As the modern era of information technology has emerged, the field of displays that visually express electrical information signals has rapidly advanced. In response, various types of display devices having excellent characteristics such as reduced thickness, lightweight design, and low power consumption have been developed. Specific examples of such display devices include Liquid Crystal Display (LCD) devices, Plasma Display Panel (PDP) devices, Field Emission Display (FED) devices, and Organic Light Emitting Display (OLED) devices.

Recently, flexible display devices manufactured using flexible materials such as plastic instead of conventional rigid glass substrates have been gaining attention as next-generation display devices. These displays can be bent like paper while maintaining display performance.

Flexible display devices may be categorized as unbreakable, having high durability (using plastic thin-film transistor substrates instead of glass), bendable (bendable while remaining intact), rollable (capable of being rolled up), or foldable (capable of being folded). These flexible display devices offer advantages in space efficiency, interior integration, and design, and may be applied in a wide range of fields.

In particular, to achieve large screen sizes along with ultra-thinness, reduced weight, and miniaturization, active research is being conducted on foldable display devices that can be carried in a folded state and display images when unfolded.

Foldable display devices may be applied not only to mobile devices such as mobile phones, ultra-mobile PCs, e-books, and e-newspapers, but also to various other applications including televisions and monitors.

The description provided in the discussion of the related art section should not be assumed to be prior art merely because it is mentioned in or associated with that section. The discussion of the related art section may include information that describes one or more aspects of the subject technology, and the description in this section does not limit the invention.

### SUMMARY

Exemplary embodiments of the present disclosure may provide a display device in which a plurality of wing plates are disposed on a rear surface of a display panel.

Exemplary embodiments of the present disclosure may provide a display device in which the plurality of wing plates support a folded display panel.

The objects of the exemplary embodiments of the present disclosure are not limited to those described herein, and other objects not specifically mentioned will be clearly understood by those skilled in the art from the following description. Exemplary embodiments of the present disclosure provide a display device according to claim 1. Further embodiments are described in the dependent claims.

Exemplary embodiments of the present disclosure may provide a display device including a display panel having a folding area and a non-folding area, at least a portion of the display panel being foldable; a first wing plate overlapping a rear surface of the display panel; a cover overlapping at least a portion of the first wing plate; a link arm having a curved shape and inserted between the first wing plate and the cover; and a second wing plate connected to the link arm and overlapping the rear surface of the display panel, wherein, as the display panel is folded, at least a portion of the second wing plate may rotate in accordance with the curved shape of the link arm.

Exemplary embodiments of the present disclosure may provide a display device including a display panel including a folding area and a non-folding area, at least a portion of the display panel being foldable; a first wing plate overlapping a rear surface of the display panel; a second wing plate overlapping the rear surface of the display panel; and a link arm having a curved shape and connecting the first wing plate and the second wing plate. As the display panel is folded, at least a portion of the second wing plate may rotate in accordance with the curved shape of the link arm.

According to exemplary embodiments of the present disclosure, a display device may be provided that includes attachment portions for attaching the display panel and the wing plates.

According to exemplary embodiments of the present disclosure, by connecting the wing plates with a link arm, the wing plates may be operated in an eco-friendly manner without being worn out or needing replacement.

The effects of the exemplary embodiments of the present disclosure are not limited to those described above, and other effects not specifically mentioned will be clearly understood by those skilled in the art based on the disclosure.

### BRIEF DESCRIPTION OF THE DRAWINGS

The present disclosure will be more fully understood from the following detailed description and the accompanying drawings. The detailed description and drawings are provided for illustrative purposes only and are not intended to limit the scope of the present disclosure.
FIG. 1 is a diagram illustrating a display device according to various exemplary embodiments of the present disclosure.
FIG. 2 is a side view of a hinge structure and a display panel while the display device according to various exemplary embodiments of the present disclosure is in an unfolded state.
FIG. 3 is a perspective view of a hinge structure and a display panel while the display device according to various embodiments of the present disclosure is in an unfolded state.
FIG. 4 is a side view of a hinge structure and a display panel while the display device according to various exemplary embodiments of the present disclosure is in a folded state.
FIG. 5 is a perspective view of a hinge structure and a display panel while the display device according to various exemplary embodiments of the present disclosure is in a folded state.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and convenience.

### DETAILED DESCRIPTION

In the following description of examples or exemplary embodiments of the present invention, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present invention, detailed descriptions of well-known functions and components incorporated herein will be omitted when it is determined that the description may make the subject matter in some embodiments of the present invention rather unclear. The terms such as "including", "having", "containing", "constituting" "make up of", and "formed of" used herein are generally intended to allow other components to be added unless the terms are used with the term "only". As used herein, singular forms are intended to include plural forms unless the context clearly indicates otherwise.

Terms, such as "first", "second", "A", "B", "(A)", or "(B)" may be used herein to describe elements of the present invention. Each of these terms is not used to define essence, order, sequence, or number of elements, etc., but is used merely to distinguish the corresponding element from other elements. For example, a first element could be termed a second element, and, similarly, a second element could be termed a first element, without departing from the scope of the present disclosure.

It should be understood that the term "at least one" includes all combinations related with any one item. For example, "at least one among a first element, a second element and a third element" may include all combinations of two or more elements selected from the first, second and third elements as well as each individual element of the first, second and third elements.

When it is mentioned that a first element "is connected or coupled to", "contacts or overlaps", etc., a second element, it should be interpreted that, not only can the first element "be directly connected or coupled to" or "directly contact or overlap" the second element, but a third element can also be "interposed" between the first and second elements, or the first and second elements can "be connected or coupled to", "contact or overlap", etc., each other via a fourth element. Here, the second element may be included in at least one of two or more elements that "are connected or coupled to", "contact or overlap", etc., each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

Where positional relationships are described, for example, where the positional relationship between two parts is described using "on," "over," "under," "above," "below," "beside," "next," or the like, one or more other parts may be located between the two parts unless a more limiting term, such as "immediate(ly)," "direct(ly)," or "close(ly)" is used. For example, where an element or layer is disposed "on" another element or layer, a third element or layer may be interposed therebetween. Furthermore, the terms "left," "right," "top," "bottom, "downward," "upward," "upper," "lower," and the like refer to an arbitrary frame of reference.

In addition, when any dimensions, relative sizes, etc., are mentioned, it should be considered that numerical values for an elements or features, or corresponding information (e.g., level, range, etc.) include a tolerance or error range that may be caused by various factors (*e.g.,* process factors, internal or external impact, noise, etc.) even when a relevant description is not specified. Further, the term "may" fully encompasses all the meanings of the term "can".

Unless otherwise defined, all terms (including technical and scientific terms) used herein have the same meaning as commonly understood by one of ordinary skill in the art to which exemplary embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Various exemplary embodiments of the present disclosure will be described in detail with reference to the accompanying drawings.

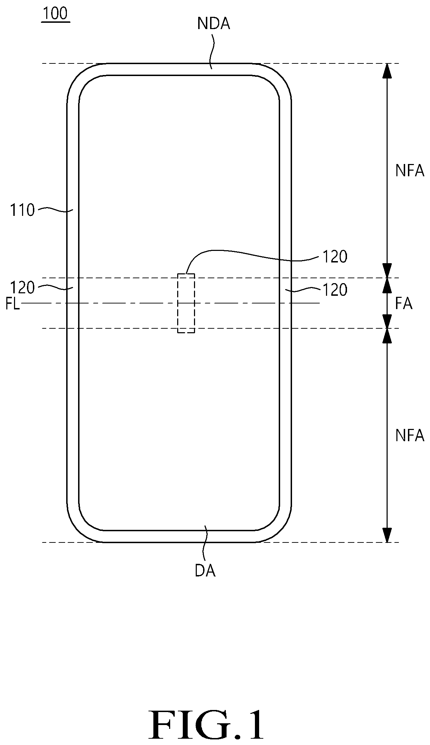

FIG. 1 illustrates a display device 100 according to various exemplary embodiments of the present disclosure.

Referring to FIG. 1, the display device 100 may include a display panel 110 and a plurality of hinge structures 120.

The display panel 110 may be foldable. At least a portion of the display panel 110 may be formed of a flexible material.

The display panel 110 may include a folding area FA, in which the display device 100 is folded with respect to a folding line FL, and a non-folding area NFA, which remains flat during folding. The non-folding area NFA may be disposed on either side or both sides of the folding area FA. For example, the folding area FA may be disposed between the non-folding areas NFA.

The display panel 110 may include a display area DA in which an image is displayed, and a non-display area NDA which defines the outer boundary of the display area and in which an image is not displayed.

At least a portion of the non-display area NDA may be bent to be invisible from the front surface of the display device 100 or may be covered by a case or housing (not shown) of the display device 100. The non-display area NDA may be also referred to as an edge area or a bezel area.

The plurality of hinge structures 120 may be located on the rear surface of the display panel 110. The plurality of hinge structures 120 may be disposed respectively at a first edge, a second edge, and a central portion of the rear surface of the display panel 110. The hinge structures 120 may be symmetrically arranged with respect to the folding line FL.

The hinge structure 120 may support the display panel 110 while it is being folded and may be configured to prevent wrinkles from forming in the display panel 110. Also, the hinge structure 120 may support the display panel 110 while it is in an unfolded state.

Hereinafter, the configurations of each hinge structure 120 will be described by way of example.

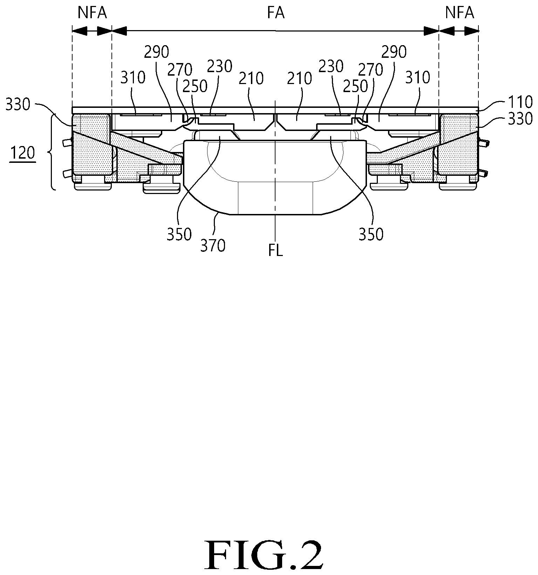

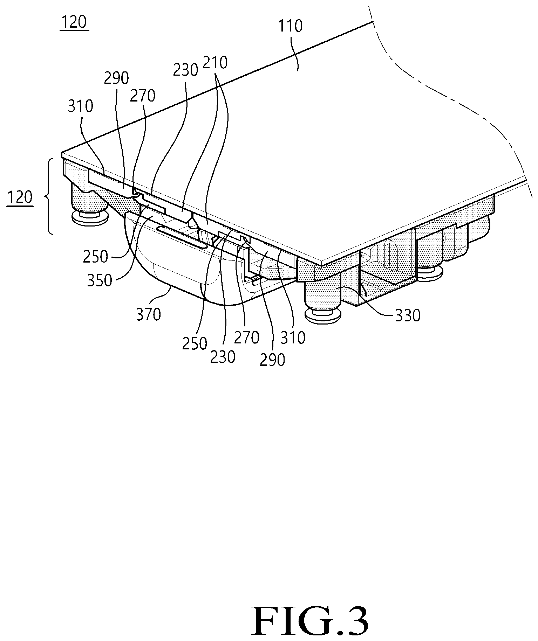

FIG. 2 is a side view of the hinge structure 120 and the display panel 110 while the display device 100 is in an unfolded state according to various exemplary embodiments of the present disclosure, and FIG. 3 is a perspective view of the hinge structure 120 and the display panel 110 while the display device 100 is in an unfolded state.

Referring to FIG. 2 and FIG. 3, the hinge structure 120 may be disposed on the rear surface of the display panel 110 and may support the display panel 110 while it is in an unfolded state.

As one example, the hinge structure 120 may include a first wing plate 210 overlapping a rear surface of the display panel 110; a cover 250 overlapping at least a portion of the first wing plate 210; a link arm 270 having a curved shape and inserted between the first wing plate 210 and the cover 250; and a second wing plate 290 connected to the link arm 270 and overlapping the rear surface of the display panel 110, but is not limited thereto.

The hinge structure 120 may include a first wing plate 210, a first attachment portion 230, a cover 250, a link arm 270, a second wing plate 290, a second attachment portion 310, a hinge arm 330, a hinge housing 350, and a hinge cover 370. The hinge structure 120 may include two of each of the first wing plate 210, the first attachment portion 230, the cover 250, the link arm 270, the second wing plate 290, and the second attachment portion 310.

The first wing plate 210 may support the display panel 110 and may overlap the rear surface of the display panel 110. At least a portion of the first wing plate 210 may be spaced apart from the display panel 110. The first wing plate 210 may be positioned corresponding to the folding area FA and may be formed of a metal material. For example, the first wing plate 210 may be positioned in the folding area FA.

At least a portion of the first wing plate 210 may be attached to at least a portion of the display panel 110. For example, the first attachment portion 230 may be disposed between the first wing plate 210 and the rear surface of the display panel 110. The first attachment portion 230 may attach at least a portion of the first wing plate 210 to the display panel 110. The first attachment portion 230 may be formed of double-sided tape, but is not limited thereto. At least a portion of the first wing plate 210 and at least a portion of the display panel 110 attached through the first attachment portion 230 may not be separated regardless of whether folding occurs. The first attachment portion 230 may be positioned corresponding to the folding area FA.

The cover 250 may overlap at least a portion of the first wing plate 210. A space for inserting the link arm 270 may be formed between the cover 250 and at least a portion of the first wing plate 210. The link arm 270 may be inserted into and separated from the formed space. The cover 250 may be positioned corresponding to the folding area FA.

The link arm 270 may have a curved shape and may connect the first wing plate 210 and the second wing plate 290. The link arm 270 may be connected to the second wing plate 290 or may be integrally formed therewith. The link arm 270 may be positioned corresponding to the folding area FA.

The second wing plate 290 may support the display panel 110 and may overlap the rear surface of the display panel 110. At least a portion of the second wing plate 290 may be spaced apart from the display panel 110. The second wing plate 290 may be positioned corresponding to the folding area FA and may be formed of a metal material. For example, the first wing plate 210 and the second wing plate 290 may be positioned corresponding to the folding area FA.

The second attachment portion 310 may attach at least a portion of the second wing plate 290 to the display panel 110. The second attachment portion 310 may be formed of double-sided tape. At least a portion of the second wing plate 290 and at least a portion of the display panel 110 attached through the second attachment portion 310 may not be separated regardless of whether folding occurs. The second attachment portion 310 may be positioned corresponding to the folding area FA.

The hinge arm 330 may be located below the second wing plate 290 and may overlap the second wing plate 290. The hinge arm 330 may support the second wing plate 290, thereby supporting the display panel 110. The hinge arm 330 may rotate as the display panel 110 is folded and may be positioned corresponding to at least a portion of the folding area FA and the non-folding area NFA.

The hinge housing 350 may be located below the cover 250, which is in contact with the first wing plate 210, and may overlap the first wing plate 210 and the cover 250. The hinge housing 350 may connect the hinge arm 330 and the hinge cover 370, and may be used for assembling the hinge cover 370 and the hinge arm 330. The hinge housing 350 may support the first wing plate 210 and the cover 250. The hinge housing 350 may be positioned corresponding to the folding area FA. An empty space may be formed in a central portion of the hinge housing 350.

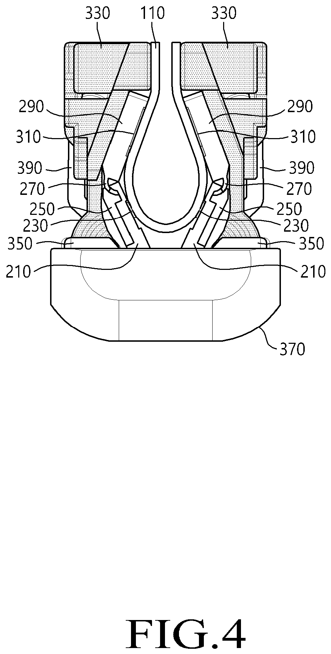

The hinge cover 370 may surround the hinge housing 350. The hinge cover 370 may be visible from the outside regardless of whether the display panel 110 is in a folded or unfolded state. The hinge cover 370 may be positioned corresponding to the folding area FA. For example, the hinge cover 370 may be used for fixing the connection member 390 and the spring member 410 (see FIG. 4).

Hereinafter, configurations of the hinge structure 120 may be illustrated while the display panel 110 is folded.

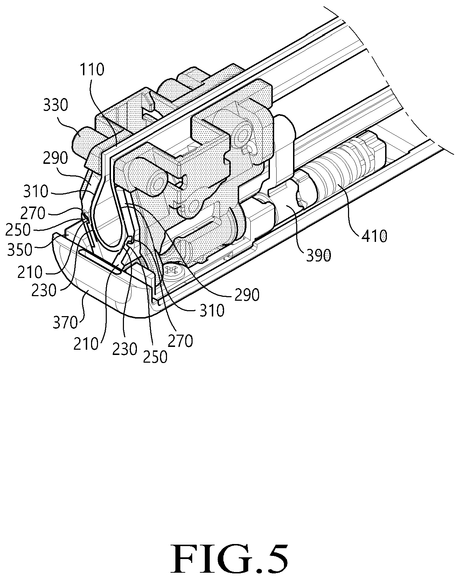

FIG. 4 is a side view of the hinge structure 120 and the display panel 110 while the display device 100 is folded, according to various exemplary embodiments of the present disclosure, and FIG. 5 is a perspective view of the hinge structure 120 and the display panel 110 while the display device 100 is folded.

Referring to FIG. 4, as the display panel 110 is folded, at least a portion of the first wing plate 210 may not be in contact with the display panel 110. For example, as the display panel 110 is folded, at least a portion of the first wing plate 210 that is not in contact with the first attachment portion 230 may not be in contact with the display panel 110. At least a portion of the first wing plate 210 that is not in contact with the display panel 110 may be positioned in an empty space at a central portion of the hinge housing 350. The hinge housing 350 may support at least a portion of the first wing plate 210. Accordingly, the strength for supporting at least a portion of the display panel 110 of the first wing plate 210 may be increased.

While the display panel 110 is folded, at least a portion of the first wing plate 210 attached through the first attachment portion 230 may support at least a portion of the display panel 110. Accordingly, at least a portion of the display panel 110 having a curved shape due to folding may be supported. As at least a portion of the display panel 110 is supported, the occurrence of wrinkles in the display panel 110 may be minimized.

As the display panel 110 is folded, at least a portion of the link arm 270 may be separated from between the cover 250 and the first wing plate 210. However, the link arm 270 may not be completely detached from between the first wing plate 210 and the cover 250. For example, when the display panel 110 is folded, at least a portion of the link arm 270 may be separated from at least a portion of the first wing plate 210 and at least a portion of the cover 250, but is not limited thereto.

As at least a portion of the link arm 270 is separated from at least a portion of the first wing plate 210 and at least a portion of the cover 250 along its curved shape (*i.e.,* as the display panel 110 is folded), the second wing plate 290 connected to the link arm 270 may rotate in accordance with the curved shape.

Accordingly, while the display panel 110 is being folded, an edge of the second wing plate 290, which was adjacent to the first wing plate 210 while the display panel 110 was not folded, may not interfere with an edge of the first wing plate 210.

As the display panel 110 is folded, at least a portion of the second wing plate 290 may not be in contact with the display panel 110. For example, when the display panel 110 is folded, at least a portion of the second wing plate 290 that is not in contact with the second attachment portion 310 may not be in contact with the display panel 110. An area of a portion of the second wing plate 290 that is not in contact with the display panel 110 may be smaller than an area of a portion of the first wing plate 210 that is not in contact with the display panel 110.

While the display panel 110 is folded, at least a portion of the second wing plate 290 attached through the second attachment portion 310 may support at least a portion of the display panel 110. Accordingly, at least a portion of the display panel 110 may be supported. As at least a portion of the display panel 110 is supported, the occurrence of wrinkles in the display panel 110 may be minimized.

In other words, as the first wing plate 210 and the second wing plate 290 respectively support at least a portion of the display panel 110 through the first attachment portion 230 and the second attachment portion 310, wrinkles generated in the display panel 110 due to stress caused by folding may be minimized.

Referring to FIG. 5, the hinge structure 120 may further include a connection member 390 and a spring member 410. The hinge housing 350, the connection member 390, and the spring member 410 may be fixed to the hinge cover 370.

As one example, the spring member 410 may be compressed or extended according to folding or unfolding of the display panel 110 and the connection member 390 has one side connected to the hinge arm 330 and the other side connected to the spring member 410, but is not limited thereto. For example, the connection member 390 rotates as the hinge arm 330 rotates.

The first wing plate 210, the second wing plate 290, the cover 250, the first attachment portion 230, the second attachment portion 310, and the hinge cover 370 of the hinge structure 120 may be positioned corresponding to the entire folding area FA. The hinge housings 350 may be respectively positioned at a first edge, a second edge, and a central portion of the rear surface of the display panel 110. The connection members 390 and the spring members 410 may each be positioned at the first edge, second edge, and central portion of the rear surface of the display panel 110 within the folding area FA. Alternatively, two connection members 390 and two spring members 410 may be positioned at each of the first edge, second edge, and central portion of the rear surface of the display panel 110 within the folding area FA.

The connection member 390 may be connected through a hole of the hinge arm 330 and a screw of the connection member 390. Accordingly, as the hinge arm 330 rotates, the connection member 390 may rotate. One side of the connection member 390 is connected to the hinge arm 330, and the other side of the connection member 390 may be connected to the spring member 410.

The spring member 410 may be connected (or brought into contact) with the connection member 390. The spring member 410 may be compressed or extended according to whether the display panel 110 is folded or not. For example, the spring member 410 may be compressed or extended according to according to folding or unfolding of the display panel 110. A frictional force may be formed between the spring member 410 and the connection member 390 according to folding or unfolding of the display panel 110 (or rotation of the connection member 390). Due to the frictional force, the spring member 410 may be compressed or extended. Torque may be generated based on the compression or extension of the spring member 410. The torque may be used to fix the folding angle of the display panel 110.

A display device according to exemplary embodiments of the present disclosure may be described as follows.

The display device may include a display panel including a folding area and a non-folding area, at least a portion of is the display panel being foldable; a first wing plate overlapping the rear surface of the display panel; a cover overlapping at least a portion of the first wing plate; a link arm inserted between the first wing plate and the cover and having a curved shape; and a second wing plate connected to the link arm and overlapping the rear surface of the display panel.

As the display panel is folded, at least a portion of the second wing plate may rotate in accordance with the curved shape of the link arm.

The first wing plate and the second wing plate may be positioned corresponding to the folding area.

The display device may further include a first attachment portion attaching at least a portion of the first wing plate to at least a portion of the display panel.

The display device may further include a second attachment portion attaching at least a portion of the second wing plate to at least a portion of the display panel.

The cover, the first attachment portion, and the second attachment portion may be positioned corresponding to the folding area.

As the display panel is folded, at least a portion of the first wing plate that is not in contact with the first attachment portion may not be in contact with the display panel.

As the display panel is folded, at least a portion of the first wing plate attached through the first attachment portion may support at least a portion of the display panel.

As the display panel is folded, at least a portion of the second wing plate that is not in contact with the second attachment portion may not be in contact with the display panel.

As the display panel is folded, an area of a portion of the second wing plate that is not in contact with the display panel may be smaller than an area of a portion of the first wing plate that is not in contact with the display panel.

As the display panel is folded, at least a portion of the link arm may be separated from between the first wing plate and the cover.

While the display panel is being folded, an edge of the first wing plate and an edge of the second wing plate may not interfere with each other.

The display device may further include a hinge arm overlapping the second wing plate and rotating as the display panel is folded.

The display device may further include a spring member that is compressed or extended according to folding or unfolding of the display panel, and a connection member having one side connected to the hinge arm and the other side connected to the spring member, the connection member rotating as the hinge arm rotates.

The hinge arm may be positioned corresponding to at least a portion of the folding area and the non-folding area.

The display device may further include a hinge cover positioned corresponding to the folding area, the hinge cover fixing the connection member and the spring member.

A display device according to exemplary embodiments of the present disclosure may be described as follows.

The display device may include a display panel including a folding area and a non-folding area, at least a portion of the display panel being foldable; a first wing plate overlapping a rear surface of the display panel; a second wing plate overlapping the rear surface of the display panel; and a link arm having a curved shape and connecting the first wing plate and the second wing plate. As the display panel is folded, at least a portion of the second wing plate may rotate in accordance with the curved shape of the link arm.

The first wing plate and the second wing plate may be positioned corresponding to the folding area.

The display device may further include a first attachment portion attaching at least a portion of the first wing plate and at least a portion of the display panel.

The display device may further include a second attachment portion attaching at least a portion of the second wing plate and at least a portion of the display panel.

The first attachment portion and the second attachment portion may be positioned corresponding to the folding area.

### EXPLANATION OF REFERENCE NUMERALS

100: display device
110: display panel
120: hinge structure
210: first wing plate
230: first attachment portion
250: cover
270: link arm
290: second wing plate
310: second attachment portion
330: hinge arm
350: hinge housing
370: hinge cover
390: connection member
410: spring member

The various embodiments described above can be combined to provide further embodiments.

## Claims

1. A display device (100) comprising:
a display panel (110) including a folding area (FA) and a non-folding area (NFA), at least a portion of the display panel (110) being foldable;
a first wing plate (210) overlapping a rear surface of the display panel (110);
a cover (250) overlapping at least a portion of the first wing plate (210);
a link arm (270) having a curved shape and inserted between the first wing plate (210) and the cover (250); and
a second wing plate (290) connected to the link arm (270) and overlapping the rear surface of the display panel (110),
wherein the display device (100) is configured such that as the display panel (110) is folded, at least a portion of the second wing plate (290) rotates in accordance with the curved shape of the link arm (270).

2. The display device (100) according to claim 1, wherein the first wing plate (210) and the second wing plate (290) are positioned corresponding to the folding area (FA).

3. The display device (100) according to claim 1 or 2, further comprising a first attachment portion (230) attaching at least a portion of the first wing plate (210) to at least a portion of the display panel (110).

4. The display device (100) according to claim 3, wherein the display device (100) is configured such that as the display panel (110) is folded, at least a portion of the first wing plate (210) that is not in contact with the first attachment portion (230) is not in contact with the display panel (110).

5. The display device (100) according to claim 3 or 4, wherein the display device (100) is configured such that as the display panel (110) is folded, at least a portion of the first wing plate (210) attached through the first attachment portion (230) supports at least a portion of the display panel (110).

6. The display device (100) according to any of claims 3 to 5, further comprising a second attachment portion (310) attaching at least a portion of the second wing plate (290) to at least a portion of the display panel (110).

7. The display device (100) according to claim 6, wherein the cover (250), the first attachment portion (230), and the second attachment portion (310) are positioned corresponding to the folding area (FA).

8. The display device (100) according to claim 6 or 7, wherein the display device (100) is configured such that as the display panel (110) is folded, at least a portion of the second wing plate (290) that is not in contact with the second attachment portion (310) is not in contact with the display panel (110).

9. The display device (100) according to any of claims 6 to 8, wherein the display device (100) is configured such that as the display panel (110) is folded, an area of the second wing plate (290) that is not in contact with the display panel (110) is smaller than an area of the first wing plate (210) that is not in contact with the display panel (110).

10. The display device (100) according to any of claims 1 to 9, wherein the display device (100) is configured such that as the display panel (110) is folded, at least a portion of the link arm (270) is separated from between the first wing plate (210) and the cover (250).

11. The display device (100) according to claim 10, wherein the display device (100) is configured such that while the display panel (110) is being folded, an edge of the first wing plate (210) and an edge of the second wing plate (290) do not interfere with each other.

12. The display device according to any of claims 1 to 11, further comprising a hinge arm (330) overlapping the second wing plate (290) and configured to rotate as the display panel (110) is folded.

13. The display device (100) according to claim 12, further comprising:
a spring member (410) that is configured to compress or extend according to folding or unfolding of the display panel (110); and
a connection member (390) having a first side connected to the hinge arm (330) and a second side connected to the spring member (410), the connection member (390) configured to rotate as the hinge arm (330) rotates.

14. The display device (100) according to claim 13, further comprising a hinge cover (370) positioned corresponding to the folding area (FA) for fixing the connection member (390) and the spring member (410).

15. The display device (100) according to any of claims 12 to 14, wherein the hinge arm (330) is positioned corresponding to at least a portion of the folding area (FA) and the non-folding area (NFA).
